# EUROPÄISCHE PATENTSCHRIFT

(11) **EP 1 545 002 B1**
(45) Veröffentlichungstag und Bekanntmachung des Hinweises auf die Patenterteilung: **16.11.2011**
(21) Anmeldenummer: 04027879.8
(22) Anmeldetag: 24.11.2004
(51) Int. Cl.: H03K 17/96, H01L 41/113

(54) **Piezoschalter**
Piezoelectric switch
Commutateur piézo-électrique

(30) Priorität: 17.12.2003 DE 10359297
(43) Veröffentlichungstag der Anmeldung: 22.06.2005
(73) Patentinhaber: Lisa Dräxlmaier GmbH, 84137 Vilsbiburg (DE)
(72) Erfinder: Steckel, Michael, 84137 Vilsbiburg (DE)
(74) Vertreter: HOFFMANN EITLE

(56) Entgegenhaltungen:
- EP-A- 0 502 452
- EP-A- 1 216 911
- EP-A2- 0 958 965
- DE-A1- 19 927 464
- US-A1- 2003 144 801

## Beschreibung

### Gebiet der Erfindung

Die Erfindung betrifft ein Betätigungselement für einen Funktionsträger in einem Kraftfahrzeug, ein System aus wenigstens zwei derartigen Betätigungselementen sowie ein Verfahren zur Herstellung eines solchen Betätigungselements oder Systems.

### Stand der Technik

In Kraftfahrzeugen können eine Vielzahl von Stellfunktionen oder Ein- und Ausschaltbefehlen für verschiedenartige Bauelemente über Betätigungselemente angewählt, aktiviert oder deaktiviert werden. So ist es beispielsweise üblich, die Fenster, das Schiebedach, die Außenspiegel oder dergleichen mittels elektrisch betätigter Stellmotoren zu verstellen, zu heben, zu senken oder zu öffnen und zu schließen. Darüber hinaus sind in Kraftfahrzeugen eine Vielzahl von Funktionstasten vorgesehen, über die elektrische Verbraucher, beispielsweise Heizungen, Lüftungen, Lichtelemente, Radio, Bordcomputer, Navigationssystem und dergleichen angeschaltet oder in jeder erdenklichen Weise verstellbar sind.

Die Betätigungselemente für derartige Funktionsträger in Kraftfahrzeugen sind üblicherweise in der Mittelkonsole, in der Instrumententafel und/oder im oder am Lenkrad angebracht. Die Ausgestaltung der verschiedenen Betätigungselemente erfolgt dabei nicht allein unter dem Gesichtspunkt einer vorteilhaften Funktionsweise, sondern muss darüber hinaus auch eine vorteilhafte Optik aufweisen. Hierzu ist es insbesondere im Bereich der Instrumententafel und des Lenkrads üblich, dass die Betätigungselemente innerhalb einer Dekorschicht angeordnet sind. Die Betätigungselemente aktivieren dabei durch Schließen eines elektrischen Kontakts ein Steuerungsgerät, das die Bewegung der einzelnen Stellmotoren für die Funktionsträger regelt.

Die Betätigungselemente sind innerhalb der Dekorschicht derart angeordnet, dass sie aus der Oberfläche fühlbar erhaben hervorstehen und vorzugsweise überdies beleuchtbar sind. Diese fühlbare und/oder beleuchtbare Anordnung der Betätigungselemente führt jedoch dazu, dass die Dekorschicht im Bereich der Betätigungselemente unterbrochen ausgestaltet sein muss. Hierdurch werden jedoch insbesondere im Bereich der Übergänge von der Dekorschicht zu den einzelnen Betätigungselementen Fugen erzeugt, in denen sich im Laufe der Zeit Verunreinigungen ansammeln, welche sowohl die Funktionsweise des Betätigungselements als auch die Optik der gesamten Dekorschicht beeinträchtigen können.

Es sind des Weiteren Piezoschalter aus dem Stand der Technik bekannt, welche beispielsweise in Cerankochfeldern, Kaffeemaschinen oder aber in sogenannten "vandalensicheren" Tastaturen, insbesondere in den Auswahltasten von Bankautomaten, verwendet werden. Derartige piezoelektrische und druckintensive Tasten sind beispielsweise aus der DE 693 04 443 T2 bekannt.

Die DE 199 27 464 A1 beschreibt ein Lenkrad mit Tastenelementen zu Betätigung von elektrisch ansteuerbaren Einrichtungen, wobei die Tastenelemente piezoelektrische Drucksensoren sind.

Die EP 1 216 911 A2 beschreibt eine Lenkvorrichtung für Kraftfahrzeuge wie etwa Motorräder oder Automobile, wobei die Lenkvorrichtung eine Greifzone aufweist, die von der Hand
eines Fahrzeugführers ergriffen wird. Diese Greifzone ist wiederum mit einem elastisch deformierbaren Element versehen, dessen Geometrie unter Einfluss der von der Hand des Fahrzeugführers aufgebrachten Drucks variabel ist. Innerhalb dieser Greifzone ist überdies ein Schalter und/oder Sensor platziert, der auf diese Variationen in der Form und/oder des Volumens der Greifzone reagiert und so eine Steuerungsvorrichtung für die Funktion des Kraftfahrzeugs wie etwa die Hupe, Scheinwerfer, Schaltungen und dergleichen aktiviert.

Die US 2003/0144801 A1 beschreibt eine Vorrichtung zur Detektion des Kontakts mit einem Betätigungselement, welches beispielhaft im Lenkrad eines Kraftfahrzeugs angebracht wird. Wenn eine Sensorvorrichtung das Nicht-Bestehen eines Kontakts mit dem Lenkrad oder eine von einer vorab festgelegten Norm abweichende Größe detektiert, wird gegebenenfalls ein Vibrationssignal als Warneinrichtung aktiviert.

Die EP 0 502 452 A1 beschreibt eine selbst leuchtende piezoelektrische Tastatur, bestehend aus mehreren Folien inklusive einer Lichtemitterfolie. Das piezoelektrische Tastenelement ist hinter einer massiven Frontplatte angeordnet und die Tastenbetätigung erfolgt durch Übertragung des Fingerdrucks auf die piezoelektrischen Elemente ohne merklichen Tastenweg. Über die Lichtemitterfolie kann das gesamte Tastenfeld beleuchtet werden, wobei Tastensymbole beliebiger Art über geeignete Masken erzeugt werden können.

Derartige piezoelektrische Tasten oder Tastaturen erweisen sich jedoch in Bezug auf eine erfühlbare Ausgestaltung der Tasten als problematisch.

### Darstellung der Erfindung

Es war daher eine Aufgabe der Erfindung, ein piezoelektrisches Betätigungselement für einen Funktionsträger in einem Kraftfahrzeug zur Verfügung zu stellen, welches die aus dem Stand der Technik bekannten Probleme nicht aufweist.

Die Aufgabe der Erfindung wird durch das piezoelektrische Betätigungselement mit den Merkmalen des Anspruchs 1, das System mit den Merkmalen des Anspruchs 15 sowie das Verfahren mit den Merkmalen des Anspruchs 19 gelöst. Vorteilhafte Ausgestaltungen der Erfindung finden sich in den jeweils abhängigen Ansprüchen.

Das erfindungsgemäße Betätigungselement für einen Funktionsträger in einem Kraftfahrzeug weist ein piezoelektrisches Element auf, welches unterhalb einer Dekorfläche angeordnet ist. Die piezoelektrischen Elemente können in einem Kraftfahrzeug unterhalb einer Dekorfläche angeordnet werden und es kann hierdurch auf mechanische Betätigungselemente, wie sie aus dem Stand der Technik bekannt sind, weitgehend verzichtet werden.

Bei Verwendung piezoelektrischer Bauelemente können auch hochwertige Dekormaterialien über die Betätigungselemente gespannt werden, da der zur Aktivierung des Betätigungselements erforderliche Betätigungsweg besonders klein, üblicherweise im Bereich von wenigen Mikrometern, ist und auch eine vergleichsweise starre Dekoroberfläche keinen wesentlichen Widerstand gegen eine derartig geringe Deformation entgegen bringt. Zudem ist durch den minimalen Deformationsweg eine nahezu verschleißfreie Ausgestaltung der Betätigungselemente möglich.

Insbesondere bei Verwendung piezoelektrischer Folien kann der Raumbedarf der Betätigungselemente auf ein Minimum reduziert werden, was das Anbringen einer größeren Anzahl von Betätigungselementen auf kleinem Raum, beispielsweise auf der Lenkradabdeckung, ermöglicht. Zudem ist die Funktionsweise eines jeden Betätigungselements in weiten Bereichen variabel einstellbar.

Das erfindungsgemäße System aus wenigstens zwei Betätigungselementen ist dadurch gekennzeichnet, dass wenigstens zwei Betätigungselemente mit einem gemeinsamen piezoelektrischen Element, vorzugsweise einer piezoelektrischen Folie, verbunden sind. Dies eröffnet die Möglichkeit, verschiedene Betätigungselemente blockweise zusammenzufassen, zu fertigen oder zu regeln, wodurch die Herstellung und der Einbau der Betätigungselemente besonders vorteilhaft vereinfacht wird.

Das erfindungsgemäße Verfahren zur Herstellung eines solchen Betätigungselements oder eines derartigen Systems beinhaltet das Anbringen des piezoelektrischen Elements an dem für das Betätigungselement vorgesehenen Ort, das Verbinden jedes piezoelektrischen Elements mit einer Auswerteeinheit und einer Steuereinheit sowie das Überdecken jedes piezoelektrischen Elements mit vorzugsweise einer einzigen Dekorfläche. Das erfindungsgemäße Verfahren ist besonders einfach durchzuführen, bietet besonders platzsparende Betätigungselemente und ist daher auch zum Anbringen von Betätigungselementen an Orten geeignet, bei denen das Bespannen mit vorzugsweise hochwertigen Dekormaterialien besonders schwierig war.

Die Erfindung bietet in ihrer Gesamtheit die Möglichkeit, Betätigungselemente in Kraftfahrzeugen vorzusehen, welche vorzugsweise individuell steuer- und regelbar sind und deren Aufbau besonders einfach und kostengünstig ist.

In einer vorteilhaften Ausgestaltung des erfindungsgemäßen Betätigungselements besteht das piezoelektrische Element aus einer piezoelektrischen Folie. In einer besonders bevorzugten Ausgestaltung besteht diese piezoelektrische Folie aus wenigstens zwei übereinander angeordneten Schichten. In einer ganz besonders bevorzugten Ausführungsform ist die piezoelektrische Folie ein Verbund mehrerer miteinander verbundener, vorzugsweise übereinander verklebter Folien. In einer überaus bevorzugten Ausführungsform des erfindungsgemäßen Betätigungselements sind die einzelnen Folien zumindest teilweise mit aktiven Flächen bedeckt. Diese aktiven Flächen können vorzugsweise im Siebdruckverfahren auf die einzelnen Folien aufgebracht worden sein.

Hierdurch wird ein Betätigungselement geschaffen, welches zum einen besonders flach und flexibel ausgestaltet ist und somit zum einen einen minimalen Raumbedarf erfordert, zum anderen besonders einfach hergestellt werden kann.

In einer weiteren vorteilhaften Ausgestaltung der Erfindung ist das piezoelektrische Element mit einem Funktionsträger verbunden, so dass die durch Druck auf das piezoelektrische Element von dem Element erzeugte Spannung und der hierdurch erzeugte elektrische Impuls direkt auf den Funktionsträger einwirken kann. In einer weiteren bevorzugten Ausführungsform der Erfindung dient dieser Funktionsträger zum An- oder Ausschalten, Öffnen und Schließen oder Verstellen von Bauteilen, Stellgliedern, elektronischen oder elektrischen Fahrzeugkomponenten oder dergleichen.

Hierdurch wird ein Betätigungselement geschaffen, das mit vorzugsweise identischem Aufbau in der Lage ist, eine Vielzahl von verschiedenartigen Funktionen auszulösen, zu beenden und/oder zu steuern.

In einer weiteren bevorzugten Ausführungsform des erfindungsgemäßen Betätigungselements ist das piezoelektrische Element mit einer Auswerteeinheit, vorzugsweise einer Auswerteelektronik, verbunden. Hierdurch wird auf vorteilhafte Weise ein Betätigungselement geschaffen, welches besonders vorteilhaft auf die verschiedenen Erfordernisse und Gegebenheiten der vom Bediener angewählten Funktionsträger abgestimmt sein kann.

In einer weiteren bevorzugten Ausführungsform der Erfindung ist die Auswerteeinheit darüber hinaus mit einer Steuereinheit verbunden. Hierdurch wird die Möglichkeit geschaffen, die einzelnen Funktionsträger vorzugsweise unabhängig von einander in einer auf den jeweiligen Funktionsträger abgestimmten Weise zu steuern. Vorzugsweise kann mittels einer derartigen Steuereinheit sowohl die Schnelligkeit als auch die Dauer einer von dem Funktionsträger ausgeführten Bewegung individuell gesteuert werden.

Beispielsweise kann es wünschenswert sein, dass bestimmte Bewegungen von Stellgliedern nur für die Dauer eines Betätigungsimpulses ausgeführt werden, wohingegen insbesondere Öffnungs- und Schließbewegungen, beispielsweise von Klappenelementen, Fensterhebern und Schiebedächern unabhängig von der Dauer der Betätigung des Betätigungselements vollständig ausgeführt werden.

In einer ganz besonders bevorzugten Ausführungsform der Erfindung sind hierzu Schwellenwerte für die Auslösung eines Stellsignals in der Auswerteeinheit gespeichert. In einer überaus bevorzugten Ausführungsform der Erfindung sind derartige Schwellenwerte die Druckdauer, die Druckkraft und/oder die Anzahl der von dem Bediener auf das Betätigungselement aufgebrachten Druckimpulse. Ebenso können diese Schwellenwerte in Form korrespondierender Spannungswerte und/oder Stromimpulse in der Auswerteeinheit gespeichert sein. Hierdurch wird eine Vorrichtung geschaffen, die es ermöglicht, dass vorzugsweise jeder einzelne Funktionsträger individuell, somit mit angepasster Druckkraft und/oder Druckdauer, angewählt werden kann. Des Weiteren besteht die Möglichkeit, ein Auslösen von Funktionsträgern durch eine versehentliche Berührung des Betätigungselements oder aber durch beispielsweise im Crashfall über einen besonders kurzen Zeitraum auf das Betätigungselement einwirkende mechanische Kräfte, sicher zu vermeiden.

In einer weiteren bevorzugten Ausführungsform der Erfindung ist das Betätigungselement, vorzugsweise eine Vielzahl von Betätigungselementen, mit einer Dekorfläche überzogen, welche in den Randbereichen des Betätigungselements nicht unterbrochen ist. In einer besonders bevorzugten Ausführungsform der Erfindung sind somit keine Fugen oder dergleichen an den Rändern eines jeden Betätigungselements vorhanden.

Hierdurch wird ein Betätigungselement geschaffen, welches ohne jede Beeinträchtigung der Funktionsweise ein Eindringen von Schmutzpartikeln oder Flüssigkeiten sicher unterbindet. Insbesondere wird die Möglichkeit, den Innenraum eines Kraftfahrzeugs feucht zu reinigen ohne die Gefahr von Beeinträchtigungen oder sogar Ausfällen einzelner oder mehrerer Betätigungselemente besonders vorteilhaft unterstützt.

In einer weiteren bevorzugten Ausführungsform weist die Dekorfläche im Bereich des Betätigungselements ein Symbol auf. In einer besonders bevorzugten Ausgestaltung der Erfindung ist dieses Symbol auf die Funktion des von dem Betätigungselements zu betätigenden Funktionsträgers abgestimmt. In einer ganz besonders bevorzugten Ausführungsform ist die Dekorfläche im Bereich des Symbols transparent ausgestaltet und erlaubt somit eine Hinterleuchtung dieses Bereichs. In einer überaus bevorzugten Ausführungsform erfolgt diese Hinterleuchtung des Symbols und/oder des Betätigungselements mittels einer Leuchtdiode und/oder mittels einer unterhalb der Dekorfläche angeordneten Leuchtfolie.

Hierdurch wird die Möglichkeit eröffnet, einzelne Betätigungselemente oder aber die gesamte Schaltfläche zu beleuchten, was insbesondere bei Dunkelheit in der Fahrgastzelle das Anwählen und Betätigen eines jeden Elements erleichtert. In besonders vorteilhafter Weise kann dabei zwischen verschiedenen Intensitäten der Hintergrundbeleuchtung gewählt werden, was beispielsweise die Anzeige eines Aktivierungshinweises für einzelne Betätigungselemente erlaubt. Dabei sind die Intensitäten vorzugsweise so abgestimmt, dass die Hinterleuchtung das Erkennen eines Aktivierungszustands auch bei Tageslicht erlaubt.

Bei Berühren des Betätigungselements erfolgt eine akustische Rückmeldung. Eine mögliche optische Rückmeldung erfolgt dabei vorzugsweise durch Einschalten einer Funktionsanzeige oder durch eine Änderung der von der Funktionsanzeige abgegebenen Lichtintensität.

Bevorzugt wird auch eine akustische Rückmeldung bei erkannter Berührung des Betätigungselements sowie bei Ausführen der von dem Bediener gewählten Funktion. Eine derartige akustische Rückmeldung erfolgt in besonders bevorzugter Weise über einen Lautsprecher, der ein von der Elektronik erzeugtes Signal akustisch umsetzt.

Eine akustische Rückmeldung kann überdies auch über ein mit dem Betätigungselement verbundenes Relais erzeugt werden, bei dem durch das Öffnen und/oder Schließen eines Kontakts ein Geräusch erzeugt wird, welches das Erkennen und Ausführen eines Bedienerbefehls anzeigt.

Gemäß der Erfindung wird die Betätigung des Betätigungselements fühlbar angezeigt. Dies erfolgt vorzugsweise durch einen mit einem Relais verbundenen Klöppel, der bei Berühren des Betätigungselements von hinten an das Betätigungselement schlägt und dem Bediener somit fühlbar anzeigt, dass der Befehl erkannt wurde und die Funktion ausgeführt wird.

In einer überaus bevorzugten Ausführungsform der Erfindung erfolgt die Anzeige auf mehr als eine der oben dargelegten Arten. So wird insbesondere eine optische und akustische Anzeige bevorzugt, gemäß der Erfindung erfolgt aber eine akustische und haptische, also fühlbare, Anzeige der Betätigung.

Gemäß eines weiteren Aspekts der Erfindung wird ein System aus wenigstens zwei oben beschriebenen Betätigungselementen zur Verfügung gestellt, bei dem die Betätigungselemente oberhalb eines gemeinsamen piezoelektrischen Elements, vorzugsweise einer piezoelektrischen Folie, angeordnet sind. Hierdurch wird die Möglichkeit eröffnet, die Signale von mehr als einem Betätigungselement in einer einzelnen Elektronik auszuwerten und/oder ein gemeinsames Steuergerät zu nutzen. In einer besonders bevorzugten Ausführungsform der Erfindung sind die Betätigungselemente dabei zumindest teilweise blockweise zusammengefasst, wobei wenigstens ein Block mit einem gemeinsamen piezoelektrischen Element verbunden ist. Hierdurch wird die Möglichkeit eröffnet, die Schaltflächen in einem Kraftfahrzeug besonders einfach und kostengünstig herzustellen.

In einer weiteren besonders bevorzugten Ausführungsform des erfindungsgemäßen Systems weisen wenigstens zwei Betätigungselemente eine gemeinsame Auswerteeinheit, vorzugsweise eine Auswerteelektronik, auf. Hierdurch wird die Möglichkeit eröffnet, Betätigungselemente, welche im Wesentlichen auf gleiche Weise wirken sollen und/oder auf eine im Wesentlichen gleiche Art angesteuert oder betätigt werden sollen, vorzugsweise blockweise zusammenzufassen. Hierdurch wird der apparative Aufwand bei Herstellung von im Fahrzeug verwendeten Schalt- und Betätigungseinheiten besonders vorteilhaft minimiert.

In einer weiteren bevorzugten Ausführungsform des erfindungsgemäßen Systems weisen wenigstens zwei Betätigungselemente eine gemeinsame Steuereinheit auf. Dies ist dann besonders vorteilhaft, wenn die Stellmotoren, welche über die verschiedenen Betätigungselemente angewählt werden, auf eine im Wesentlichen identische Weise agieren sollen. Dies ist beispielsweise bei der Steuerung elektrischer Fensterheber, elektrischer Außenspiegelverstellungen oder dergleichen gegeben.

Gemäß eines dritten Aspekts der vorliegenden Erfindung wird ein Verfahren zur Herstellung eines oben beschriebenen Betätigungselements oder eines vorab beschriebenen Systems zur Verfügung gestellt. Das Verfahren umfasst das Herstellen eines vorzugsweise folienförmigen piezoelektrischen Elements, dessen Anbringen an der dafür vorgesehenen Stelle im Kraftfahrzeug, das Verbinden jedes piezoelektrischen Elements mit einer Auswerteeinheit und einer Steuereinheit sowie das Überdecken jedes piezoelektrischen Elements mit einer Dekorfläche.

In besonders vorteilhafter Weise erfolgt das Überdecken aller piezoelektrischen Elemente mit einer einzigen Dekorfläche. Hierdurch wird ein Verfahren zur Verfügung gestellt, das besonders einfach durchzuführen ist und eine Dekorfläche mit einem Minimum an Fugen zur Verfügung stellt. Hierdurch wird ein Eindringen von Schmutzpartikeln oder Flüssigkeiten unter die Dekorfläche sicher unterbunden, des Weiteren weist die Dekorfläche auch keine Öffnungen auf, von denen aus eine Risseinleitung in die Dekorfläche ausgehen könnte.

In einer bevorzugten Ausführungsform des erfindungsgemäßen Verfahrens werden unterhalb der Dekorschicht zusätzliche Hinterleuchtungsmittel, vorzugsweise Leuchtdioden und/oder Leuchtfolien angeordnet. In ganz besonders bevorzugter Ausführungsform des erfindungsgemäßen Verfahrens dient eine gemeinsame Leuchtfolie der Hinterleuchtung einer Mehrzahl von Betätigungselementen.

In einer weiteren bevorzugten Ausführungsform des erfindungsgemäßen Verfahrens wird das piezoelektrische Element aus einem Verbund übereinander angeordneter Folien erstellt, deren aktiven Flächen im Siebdruckverfahren hergestellt sind. Dies eröffnet die Möglichkeit, die piezoelektrische Folie mit besonders einfachen und überdies genau zu beherrschenden Verfahren herzustellen.

### Kurze Beschreibung der Zeichnung

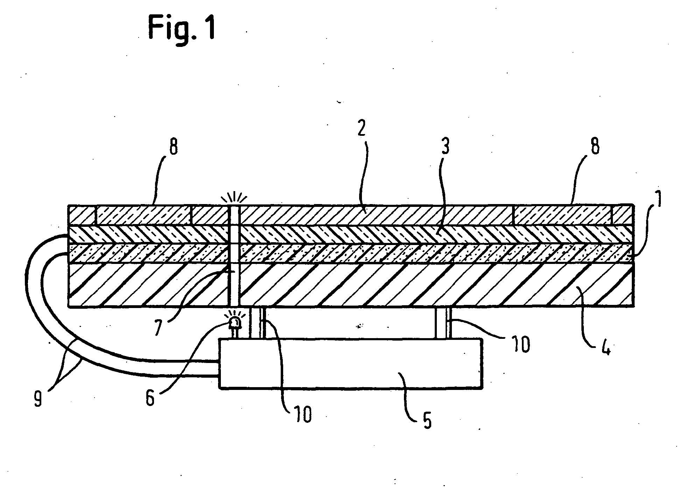

Die vorliegende Erfindung wird nachfolgend anhand der Fig. 1 näher erläutert, wobei diese Figur lediglich eine exemplarische Ausführungsform eines erfindungsgemäßen Systems zeigt. Die Figur ist jedoch nicht geeignet, den allgemeinen Gedanken der Erfindung in irgendeiner Weise einzuschränken.

Fig. 1 zeigt eine geschnittene Seitenansicht eines erfindungsgemäßen Systems.

### Wege zur Ausführung der Erfindung

In Fig. 1 wird ein System aus zwei oberhalb einer einzigen piezoelektrischen Folie 1 angeordneten Betätigungselementen dargestellt. Das System ist auf einem Funktionsträger 4, beispielsweise eine Instrumententafel, angeordnet und weist eine Piezofolie 1, eine oberhalb der Piezofolie 1 angeordnete Leuchtfolie 3 sowie eine abschließende Dekoroberfläche 2 auf. In dieser Dekoroberfläche 2 sind transparente Tastflächen 8 angeordnet, durch die das von der Leuchtfolie 3 abgegebene Licht hindurchscheinen kann. Mit der piezoelektrischen Folie 1 und der Leuchtfolie 3 ist über die Leitungen 9 eine Auswerte- und Steuerelektronik 5 angeschlossen, mittels derer zum einen die über die Tastflächen 8 auf die Piezofolie 1 aufgegebenen Kräfte detektiert werden als auch ein etwaiges Leuchten der Leuchtfolie 3 aktiviert wird. Mit der Elektronik 5, die über Befestigungsmittel 10 mit dem Funktionsträger 4 verbunden ist, ist zudem eine Leuchtdiode 6 verbunden, deren Licht im Falle einer Aktivierung durch die Elektronik 5, durch den durch den Funktionsträger 4, die piezoelektrische Folie 1, die Leuchtfolie 3 sowie die Dekoroberfläche 2 hindurch führenden Kanal 7 hindurch nach außen fallen kann.

## Patentansprüche

1. Piezoelektrisches Betätigungselement für einen Funktionsträger (4) in einem Kraftfahrzeug mit einem piezoelektrischen Element (1), vorzugsweise einer piezoelektrischen Folie und einer oberhalb des piezoelektrischen Elements (1) angeordneten Dekorfläche (2), **dadurch gekennzeichnet, dass** das Berühren des piezoelektrischen Betätigungselements durch eine Rückmeldung anzeigbar ist und die Rückmeldung akustisch und fühlbar erfolgt.

2. Piezoelektrisches Betätigungselement nach Anspruch 1, **dadurch gekennzeichnet, dass** die piezoelektrische Folie einen Aufbau aus wenigstens zwei Schichten aufweist.

3. Piezoelektrisches Betätigungselement nach einem der voranstehenden Ansprüche, **dadurch gekennzeichnet, dass** die piezoelektrische Folie ein Verbund mehrerer miteinander verbundener, vorzugsweise übereinander verklebter, Folien ist.

4. Piezoelektrisches Betätigungselement nach Anspruch 3, **dadurch gekennzeichnet, dass** die einzelnen Folien zumindest teilweise mit aktiven Flächen bedeckt, vorzugsweise im Siebdruckverfahren bedruckt sind.

5. Piezoelektrisches Betätigungselement nach einem der voranstehenden Ansprüche, **dadurch gekennzeichnet, dass** die Funktionsträger (4) zum An- oder Ausschalten, Öffnen und Schließen oder Verstellen von Bauteilen, Stellgliedern, elektronischen oder elektrischen Fahrzeugkomponenten oder dergleichen dienen.

6. Piezoelektrisches Betätigungselement nach einem der voranstehenden Ansprüche, **dadurch gekennzeichnet, dass** das piezoelektrische Element (1) mit einem Funktionsträger (4) verbunden ist.

7. Piezoelektrisches Betätigungselement nach einem der voranstehenden Ansprüche, **dadurch gekennzeichnet, dass** das piezoelektrische Element (1) mit einer Auswerteeinheit, vorzugsweise einer Auswerteelektronik, verbunden ist.

8. Piezoelektrisches Betätigungselement nach einem der voranstehenden Ansprüche, **dadurch gekennzeichnet, dass** die Auswerteeinheit mit einer Steuereinheit verbunden ist.

9. Piezoelektrisches Betätigungselement nach einem der Ansprüche 7 oder 8, **dadurch gekennzeichnet, dass** Schwellenwerte für die Auslösung eines Stellsignals in der Auswerteeinheit gespeichert sind.

10. Piezoelektrisches Betätigungselement nach Anspruch 9, **dadurch gekennzeichnet, dass** die Schwellenwerte die Druckdauer, die Druckkraft und/oder die Anzahl der Druckimpulse oder mit diesen korrespondierende Spannungswerte und/oder Stromimpulse sind.

11. Piezoelektrisches Betätigungselement nach einem der voranstehenden Ansprüche, **dadurch gekennzeichnet, dass** die Dekorfläche (2) in den Randbereichen des Betätigungselements nicht unterbrochen ist und vorzugsweise keine Fugen oder dergleichen aufweist.

12. Piezoelektrisches Betätigungselement nach einem der voranstehenden Ansprüche, **dadurch gekennzeichnet, dass** die Dekorfläche (2) im Bereich des Betätigungselements ein Symbol, vorzugsweise ein Symbol für den Funktionsträger (4), aufweist.

13. Piezoelektrisches Betätigungselement nach Anspruch 12, **dadurch gekennzeichnet, dass** die Dekorfläche (2) im Bereich des Symbols transparent ist und eine Hinterleuchtung des Betätigungselements aufweist.

14. Piezoelektrisches Betätigungselement nach Anspruch 13, **dadurch gekennzeichnet, dass** das Betätigungselement mittels einer Leuchtdiode und/oder mittels einer unterhalb der Dekorfläche (2) angeordneten Leuchtfolie (3) beleuchtbar ist.

15. System aus wenigstens zwei piezoelektrischen Betätigungselementen gemäß der voranstehenden Ansprüche 1 - 14, **dadurch gekennzeichnet, dass** die Betätigungselemente ein gemeinsames piezoelektrisches Element (1), vorzugsweise eine piezoelektrische Folie, aufweisen.

16. System nach Anspruch 15, **dadurch gekennzeichnet, dass** die piezoelektrischen Betätigungselemente zumindest teilweise blockweise zusammengefasst sind und wenigstens ein Block ein gemeinsames piezoelektrisches Element (1) aufweist.

17. System nach einem der Ansprüche 15 oder 16, **dadurch gekennzeichnet, dass** wenigstens zwei piezoelektrische Betätigungselemente eine gemeinsame Auswerteeinheit, vorzugsweise eine Auswerteelektronik, aufweisen.

18. System nach einem der Ansprüche 15 - 16, **dadurch gekennzeichnet, dass** wenigstens zwei piezoelektrische Betätigungselemente eine gemeinsame Steuereinheit aufweisen.

19. Verfahren zur Herstellung eines piezoelektrischen Betätigungselementes nach einem der Ansprüche 1 - 14 oder eines Systems nach einem der Ansprüche 15 - 18, mit den Schritten:
- Herstellen zumindest eines vorzugsweise folienförmigen piezoelektrischen Elements (1),
- Anbringen zumindest eines piezoelektrischen Elements (1),
- Verbinden jedes piezoelektrischen Elements (1) mit einer Auswerteeinheit und einer Steuereinheit, und
- Überdecken jedes piezoelektrischen Elements (1) mit vorzugsweise einer Dekorfläche (2).

20. Verfahren nach Anspruch 19, **dadurch gekennzeichnet, dass** unterhalb der Dekorfläche (2) Beleuchtungsmittel, vorzugsweise Leuchtdioden und/oder eine oder mehrere Leuchtfolien (3), angeordnet werden.

21. Verfahren nach einem der Ansprüche 19 oder 20, **dadurch gekennzeichnet, dass** das piezoelektrische Element (1) eine piezoelektrische Folie, bestehend aus einem Verbund übereinander angeordneter Folien ist, deren aktive Flächen im Siebdruckverfahren hergestellt sind.

## Claims

1. Piezoelectric actuating element for a function carrier (4) in a motor vehicle having a piezoelectric element (1), preferably a piezoelectric foil, and a decorative surface (2) arranged above the piezoelectric element (1), **characterised in that** contact of the piezoelectric actuating element can be indicated by a response and the response is given acoustically and tangibly.

2. Piezoelectric actuating element according to claim 1, **characterised in that** the piezoelectric foil has a structure consisting of at least two layers.

3. Piezoelectric actuating element according to either of the preceding claims, **characterised in that** the piezoelectric foil is a composite of several foils joined together, preferably adhered one above the other.

4. Piezoelectric actuating element according to claim 3, **characterised in that** the individual foils are at least partially covered with active surfaces, preferably printed by silkscreen printing.

5. Piezoelectric actuating element according to any of the preceding claims, **characterised in that** the function carriers (4) are used to switch on or off, open and close or adjust components, final control elements, electronic or electrical vehicle components or the like.

6. Piezoelectric actuating element according to any of the preceding claims, **characterised in that** the piezoelectric element (1) is connected to a function carrier (4).

7. Piezoelectric actuating element according to any of the preceding claims, **characterised in that** the piezoelectric element (1) is connected to an evaluating unit, preferably an electronic evaluating unit.

8. Piezoelectric actuating element according to any of the preceding claims, **characterised in that** the evaluating unit is connected to a control unit.

9. Piezoelectric actuating element according to either of claims 7 or 8, **characterised in that** threshold values are stored in the evaluating unit for triggering an adjusting signal.

10. Piezoelectric actuating element according to claim 9, **characterised in that** the threshold values are the compression time, the compressive force and/or the number of pressure pulses or voltage values and/or current pulses corresponding to the latter.

11. Piezoelectric actuating element according to any of the preceding claims, **characterised in that** the decorative surface (2) is not interrupted in the edge regions of the actuating element and preferably has no gaps or the like.

12. Piezoelectric actuating element according to any of the preceding claims, **characterised in that** the decorative surface (2) has a symbol, preferably a symbol of the function carrier (4), in the region of the actuating element.

13. Piezoelectric actuating element according to claim 12, **characterised in that** the decorative surface (2) is transparent in the region of the symbol and has backlighting of the actuating element.

14. Piezoelectric actuating element according to claim 13, **characterised in that** the actuating element can be illuminated by means of a light-emitting diode and/or by means of a light-emitting foil (3) arranged below the decorative surface (2).

15. System consisting of at least two piezoelectric actuating elements according to the preceding claims 1 - 14, **characterised in that** the actuating elements have a common piezoelectric element (1), preferably a piezoelectric foil.

16. System according to claim 15, **characterised in that** the piezoelectric actuating elements are at least partially combined in blocks and at least one block has a common piezoelectric element (1).

17. System according to either of claims 15 or 16, **characterised in that** at least two piezoelectric actuating elements have a common evaluating unit, preferably an electronic evaluating unit.

18. System according to either of claims 15 - 16, **characterised in that** at least two piezoelectric actuating elements have a common control unit.

19. Method for manufacturing a piezoelectric actuating element according to any of claims 1 - 14 or a system according to any of claims 15 - 18, with the steps of:
- manufacturing at least one preferably foil-like piezoelectric element (1),
- mounting at least one piezoelectric element (1),
- connecting each piezoelectric element (1) to an evaluating unit and a control unit, and
- covering each piezoelectric element (1) with preferably a decorative surface (2).

20. Method according to claim 19, **characterised in that** below the decorative surface (2) are arranged lighting means, preferably light-emitting diodes and/or one or more light-emitting foils (3).

21. Method according to either of claims 19 or 20, **characterised in that** the piezoelectric element (1) is a piezoelectric foil, consisting of a composite of foils arranged one above the other, of which the active surfaces are made by silkscreen printing.

## Revendications

1. Elément d'actionnement piézo-électrique, pour un support fonctionnel (4) dans un véhicule automobile avec un élément piézo-électrique (1), de préférence une feuille piézo-électrique, et une face de décor (2), disposée au-dessus de l'élément piézo-électrique (1), **caractérisé en ce que** le contact de l'élément d'actionnement piézo-électrique est susceptible d'être affiché au moyen d'une information en retour, et l'information en retour s'effectue de manière acoustique et sensible.

2. Elément d'actionnement piézo-électrique selon la revendication 1, **caractérisé en ce que** la feuille piézo-électrique présente une structure composée d'au moins deux couches.

3. Elément d'actionnement piézo-électrique l'une des revendications précédentes, **caractérisé en ce que** la feuille piézo-électrique est un composite de plusieurs feuilles reliées ensemble, de préférence collées les unes au-dessus des autres.

4. Elément d'actionnement piézo-électrique selon la revendication 3, **caractérisé en ce que** les différentes feuilles sont couvertes au moins partiellement avec des faces actives, de préférence sont imprimées selon un procédé d'impression sérigraphique.

5. Elément d'actionnement piézo-électrique l'une des revendications précédentes, **caractérisé en ce que** les supports fonctionnels (4) servent au branchement de connexion ou à la déconnexion, à l'ouverture et à la fermeture, ou à la manoeuvre de pièces de construction, d'organes de réglage, de composants, électroniques ou électriques, de véhicules, ou analogue.

6. Elément d'actionnement piézo-électrique l'une des revendications précédentes, **caractérisé en ce que** l'élément piézo-électrique (1) est relié à un support fonctionnel (4).

7. Elément d'actionnement piézo-électrique l'une des revendications précédentes, **caractérisé en ce que** l'élément piézo-électrique (1) est relié à une unité d'évaluation, de préférence une électronique d'évaluation.

8. Elément d'actionnement piézo-électrique l'une des revendications précédentes, **caractérisé en ce que** l'unité d'évaluation est reliée à une unité de commande.

9. Elément d'actionnement piézo-électrique l'une des revendications 7 ou 8, **caractérisé en ce que** des valeurs de seuil pour le déclenchement d'un signal de réglage sont mémorisées dans l'unité d'évaluation.

10. Elément d'actionnement piézo-électrique selon la revendication 9, **caractérisé en ce que** les valeurs de seuil sont la durée de pression, la force de pression et/ou le nombre des impulsions de pression, ou des valeurs de tension et/ou des impulsions de courant correspondant à celles-ci.

11. Elément d'actionnement piézo-électrique l'une des revendications précédentes, **caractérisé en ce que** la face de décor (2) n'est pas interrompue dans les zones de bordure de l'élément d'actionnement et ne présente de préférence aucun joint ou analogue.

12. Elément d'actionnement piézo-électrique l'une des revendications précédentes, **caractérisé en ce que**, dans la zone de l'élément d'actionnement, la face de décor (2) présente un symbole, de préférence un symbole pour le support fonctionnel (4).

13. Elément d'actionnement piézo-électrique selon la revendication 12, **caractérisé en ce que**, dans la zone du symbole, la face de décor (2) est transparente et présente un rétro-éclairage de l'élément d'actionnement.

14. Elément d'actionnement piézo-électrique selon la revendication 13, **caractérisé en ce que** l'élément d'actionnement est susceptible d'être éclairé au moyen d'une photodiode et/ou au moyen d'une feuille d'éclairage (3) disposée au-dessous de la face de décor (2).

15. Système composé d'au moins deux éléments d'actionnement piézo-électriques selon l'une des revendications 1 à 14 précédentes, **caractérisé en ce que** les éléments d'actionnement présentent un élément piézo-électrique (1) commun, de préférence une feuille piézo-électrique.

16. Système selon la revendication 15, **caractérisé en ce que** les éléments d'actionnement piézo-électriques sont regroupés au moins partiellement en blocs, et au moins un bloc présente un élément piézo-électrique (1) commun.

17. Système selon l'une des revendications 15 ou 16, **caractérisé en ce qu'**au moins deux éléments d'actionnement piézo-électriques présentent une unité d'évaluation commune, de préférence une électronique d'évaluation.

18. Système selon l'une des revendications 15 à 16, **caractérisé en ce qu'**au moins deux éléments d'actionnement piézo-électriques présentent une unité de commande commune.

19. Procédé de fabrication d'un élément d'actionnement piézo-électrique selon l'une des revendications 1 à 14, ou d'un système selon l'une des revendications 15 à 18, comprenant les étapes consistant à :
- fabriquer au moins un élément piézo-électrique (1), de préférence se présentant sous forme de feuille,
- monter au moins un élément piézo-électrique (1),
- relier chaque élément piézo-électrique (1) à une unité d'évaluation et une unité de commande, et
- recouvrir chaque élément piézo-électrique (1) avec, de préférence, une feuille de décor (2).

20. Procédé selon la revendication 19, **caractérisé en ce que** des moyens d'éclairage, de préférence des photodiodes et/ou une ou plusieurs feuilles d'éclairage (3), sont disposés au-dessous de la face de décor (2).

21. Procédé selon l'une des revendications 19 ou 20, **caractérisé en ce que** l'élément piézo-électrique (1) est une feuille piézo-électrique, constituée d'un composite de feuilles disposées les unes au-dessus des autres, dont les faces actives sont fabriquées en un procédé d'impression sérigraphique.
